# EUROPÄISCHE PATENTSCHRIFT

(11) **EP 0 818 133 B1**
(45) Veröffentlichungstag und Bekanntmachung des Hinweises auf die Patenterteilung: **15.09.1999**
(21) Anmeldenummer: 96904754.7
(22) Anmeldetag: 08.03.1996
(51) Int. Cl.: H05K 5/00

(54) **STEUERGERÄT FÜR EIN KRAFTFAHRZEUG**
CONTROL UNIT FOR A MOTOR VEHICLE
UNITE DE COMMANDE D'UN VEHICULE AUTOMOBILE

(30) Priorität: 31.03.1995 DE 19512255
(43) Veröffentlichungstag der Anmeldung: 14.01.1998
(73) Patentinhaber: SIEMENS AKTIENGESELLSCHAFT, 80333 München (DE)
(72) Erfinder: BIEREK, Norbert, D-93342 Saal (DE); PLANKL, Christian, D-93055 Burgweinting (DE); DIRMEYER, Josef, D-92439 Bodenwöhr (DE)
(86) Internationale Anmeldenummer: DE9600424
(87) Internationale Veröffentlichungsnummer: WO9631104

(56) Entgegenhaltungen:
- DE-A- 3 005 856
- DE-A- 3 629 296
- DE-A- 4 212 369
- DE-A- 4 237 870
- DE-U- 8 903 468

## Beschreibung

Die Erfindung betrifft ein Steuergerät für ein Kraftfahrzeug gemäß Oberbegriff von Patentanspruch 1.

Ein bekanntes Steuergerät für ein Kraftfahrzeug (DE 42 12 369 A1) enthält eine auf einer Leiterplatte angeordnete elektrische Schaltung. Die Leiterplatte ist in einem Gehäuse mit drei Gehäuseteilen angeordnet. Das Gehäuse wird mit einem Karosserieteil des Kraftfahrzeugs verschraubt.

Die Herstellung und Montage eines solchen Steuergeräts weist eine große Anzahl von Arbeitsschritten auf: Die Gehäuseteile werden einzeln hergestellt. Die Leiterplatte wird zumindest an einem Gehäuseteil befestigt. Die Gehäuseteile werden mechanisch miteinander verbunden. Am Band wird das Steuergerät unter großem Zeitaufwand mit dem Karosserieteil des Fahrzeugs verschraubt. Das Verschrauben erfordert zudem ausreichend Raum zum Ansetzen und Betätigen von Schraubwerkzeug. Dieser Raum ist in Fahrzeugen nicht in ausreichendem Maß vorhanden.

Aus der DE 38 09 607 A1 und der DE 93 05 939 U1 sind Steckbaugruppen bekannt, die in Baugruppenträger eingeschoben werden. Dabei ist eine eine elektrische Schaltung tragende Leiterplatte derart zwischen zwei metallische Deckel eingespannt, daß die Schaltung infolge der Deckel gegen elektromagnetsiche Strahlung geschützt ist und die Leiterplatte seitlich über die Deckel hinausragt.

Aufgabe der Erfindung ist es, ein Steuergerät für ein Kraftfahrzeug zu schaffen, das die Nachteile des bekannten Steuergeräts vermeidet, und das insbesondere aufgrund seines Aufbaus einfach, in kurzer Zeit und kostengünstig hergestellt und montiert werden kann.

Diese Aufgabe wird durch die Merkmale des Patentanspruchs 1 gelöst.

Ein Aufnahmekörper des Steuergeräts, beispielsweise ein Stanz-Biegeteil, wird beim Herstellen der Fahrzeugkarosserie an ein Karosserieteil, beispielsweise den Fahrzeugtunnel, angeschweißt und ist damit integraler Bestandteil der Karosserie. Ggf. kann der Aufnahmekörper auch einstückig mit dem entsprechenden Karosserieteil hergestellt sein. In jedem Fall ist der Aufnahmekörper fest im Sinne einer unlösbaren Verbindung mit der Karosserie verbunden. Die bei bekannten Steuergeräten zeit- und kostenintensive Schraubverbindung zwischen Aufnahmekörper und Karosserieteil sowie die aufwendige Herstellung von mehreren Gehäuseteilen und das Verschrauben der Gehäuseteile untereinander entfällt.

Der die Steuerschaltung tragende Träger ist in nutförmige Aufnahmen des Aufnahmekörpers eingeschoben.

Aufgrund des Einsatzes des Steuergeräts im Kraftfahrzeug muß die Schaltung vor mechanischen Einwirkungen, vor Umwelteinflüssen wie Feuchtigkeit usw. und vor elektromagnetischer Strahlung wirksam geschützt werden. Dazu wird erfindungsgemäß die auf dem Träger angeordnete Schaltung bzw. deren Bauelemente von einem Einschubkörper ummantelt, sodaß die Schaltung vor mechanischer Einwirkung und Feuchtigkeit bei ihrem Transport zum Fahrzeug, während des Einbaus und während ihres Betriebs im Fahrzeug geschützt ist. Dabei ist der Träger mit der Schaltung vorzugsweise bis auf zwei Randbereiche in dem Einschubkörper eingebettet. Diese Randbereiche ragen über zumindest zwei Seitenflächen des Einschubkörpers hinaus, sodaß der Träger mit den hinausragenden Bereichen in nutförmige Aufnahmen des Aufnahmekörpers eingeschoben werden kann. Der Aufnahmekörper aus Metall oder anderen geeigneten Werkstoffen schirmt die Schaltung von elektromagnetischer Einstrahlung ab.

Durch die Erfindung wird ein Steuergerät bereitgestellt, bei dem der Einschubkörper einfach, sicher und schnell in dem Aufnahmekörper befestigt werden kann.

Vorteilhafte Weiterbildungen sind in den Unteransprüchen gekennzeichnet.

Zur Gewährleistung der Betriebssicherheit ist der Träger von einem aushärtbaren Kunststoffschaum oder sonstigen nichtleitenden Schaum umgeben - vorzugsweise Polyurethan -, der im ausgehärteten Zustand die Form des Einschubkörpers annimmt. Ein aushärtbarer Kunststoff ist gegenüber einem gespritzten Kunststoff insofern von Vorteil, da der aushärtbare Kunststoff mit niedriger Temperatur auf die Bauelemente aufgebracht werden kann, ohne daß diese durch Hitzeeinwirkung zerstört werden. Zum anderen erfolgt das Aufbringen des Schaums auf die Schaltung mit wesentlich niedrigerem Druck als das Kunststoffspritzen, was ebenfalls vorteilhaft für die Funktionstüchtigkeit der Schaltung und ihrer Bauelemente ist.

Zur Sicherung des Einschubkörpers im Aufnahmekörper dienen in vorteilhafter Weise im Aufnahmekörper angeordnete Federlappen, die in entsprechende Ausnehmungen des Trägers des Einschubkörpers eingreifen. Damit sind Sicherungen mittels Schrauben, Nieten usw. nicht erforderlich.

Weiter können am Aufnahmekörper angeordnete Sicken die Steifigkeit des Aufnahmekörpers verbessern und damit auch - bei einem Airbag-Steuergerät - die Übertragung von Crash-Signalen auf Sensoren im Einschubkörper verbessert wird.

Der Einschubkörper wird in eine Öffnung des Aufnahmekörpers eingeschoben. Über diese Öffnung kann störende elektromagnetischer Strahlung auf die Schaltung im Inneren des Aufnahmekörpers einwirken. Vorzugsweise ragt deshalb der Aufnahmekörper im Bereich der Öffnung über den eingeführten Einschubkörper hinaus, sodaß in Bezug auf die Störstrahlung ein sogenannter Hohlleitereffekt eintritt, durch den die Einstrahlungsfestigkeit ohne weitere zusätzliche Maßnahmen auf das erforderliche Maß gebracht werden kann.

Ist das Steuergerät als Airbag-Steuergerät ausgebildet, so wird durch den guten Kontakt durch das formschlüssige Einschieben des Trägers in den Aufnahmekörper zudem die Übertragung von Crash-Signalen auf die im Inneren des Einschubkörpers vorhandenen und auf dem Träger befestigten Sensoren verbessert.

Der Träger kann als herkömmliche Leiterplatte oder auch als eine aus einem Metallband gestanzte Leiterplatte (Leadframe) ausgebildet sein. Ist die Leiterplatte ein Stanzteil, so kann über das in den metallischen Aufnahmekörper eingeschobene und die Schaltung enthaltende Stanzteil, das damit zumindest teilweise mit dem Aufnahmekörper elektrisch verbunden ist, ohne zusätzlichen Aufwand
- das Massepotential der Schaltung auf das Potential des Aufnahmekörpers gelegt werden,
- Wärme von auf dem Stanzteil angeordneten Leistungsbauelementen abgeleitet werden, und
- elektromagnetische Störstrahlung von der Schaltung auf den Aufnahmekörper abgeleitet werden und damit der EMV-Schutz des Steuergeräts verbessert werden.

Vorzugsweise enthält der Einschubkörper einen Stecker, der mit einem Gegenstecker eine Steckverbindung bildet, über die das Steuergerät beispielsweise mit einer Stromversorgung, mit Sensorik und Aktuatorikeinrichtungen oder mit anderen Steuergeräten elektrisch verbunden ist. Dabei ist beispielsweise ein Teil des Einschubkörpers als Steckerkörper ausgebildet, der Anschlußstifte umschließt. Ist der Träger als Stanzteil ausgebildet, so können einzelne ausgestanzte Metallbahnen als Anschlußstifte des Steckers verwendet werden.

Vorzugsweise ist der Gegenstecker mit dem Aufnahmekörper verbunden, beispielsweise über Rasthaken. Dadurch wird der Monteur veranlaßt, den Gegenstecker vor dem Einschieben des Einschubkörpers inklusive Steckerkörper in den Aufnahmekörper mechanisch mit dem Aufnahmekörper zu verbinden. So wird eine bei bekannten Airbag-Steuergeräten durchaus mögliche Fehlauslösung des Airbags während der Montage verhindert: Bislang wurden Steuergeräte oftmals mit dem Gegenstecker verbunden, bevor das Steuergerät im Fahrzeug verschraubt wurde. Bei einem versehentlichen Fallenlassen des bereits angesteckten aber noch nicht befestigten Steuergeräts und gleichzeitig eingeschalteter Stromversorgung konnte der Airbag unerwünscht ausgelöst werden. Bei dem erfindungsgemäßen Steuergerät kann eine elektrische Steckverbindung mit dem Gegenstecker jedoch nur bei eingeschobenen Einschubkörper erfolgen, wobei ein Fallenlassen des Steuergeräts in diesem Zustand nicht mehr möglich ist.

Die Erfindung und ihre Weiterbildungen werden nun anhand von sechs Figuren näher erläutert. Es zeigen:
- Figur 1 bis 3: einen Einschubkörper in Form eines Airbag-Steuergeräts, in
- Figur 1: einer Seitenansicht,
- Figur 2: einer Draufsicht, und
- Figur 3: einer Ansicht von der Steckerseite her
- Figur 4 bis 6: ein Steuergerät mit einem Aufnahmekörper mit dem eingeschobenen Einschubkörper, in

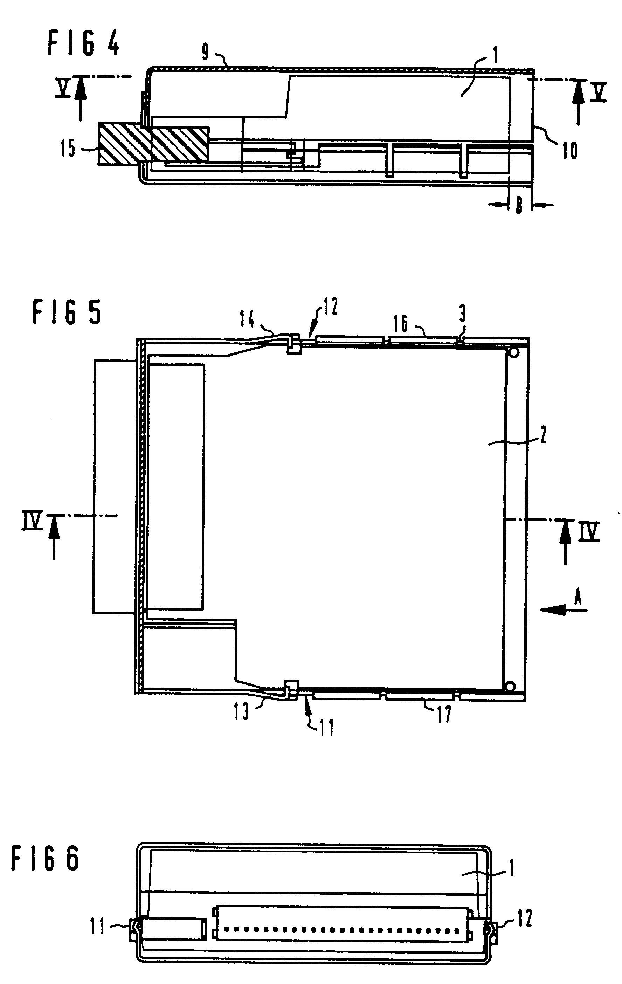

- Figur 4: einem Längsschnitt des Steuergeräts gemäß V-V in Figur 5,
- Figur 5: einer Schnittansicht des Steuergeräts gemäß IV-IV in Figur 4, aber entgegengesetzt der in Figur 4 eingezeichneten Pfeilrichtung, und
- Figur 6: einer Ansicht von der Steckerseite her.

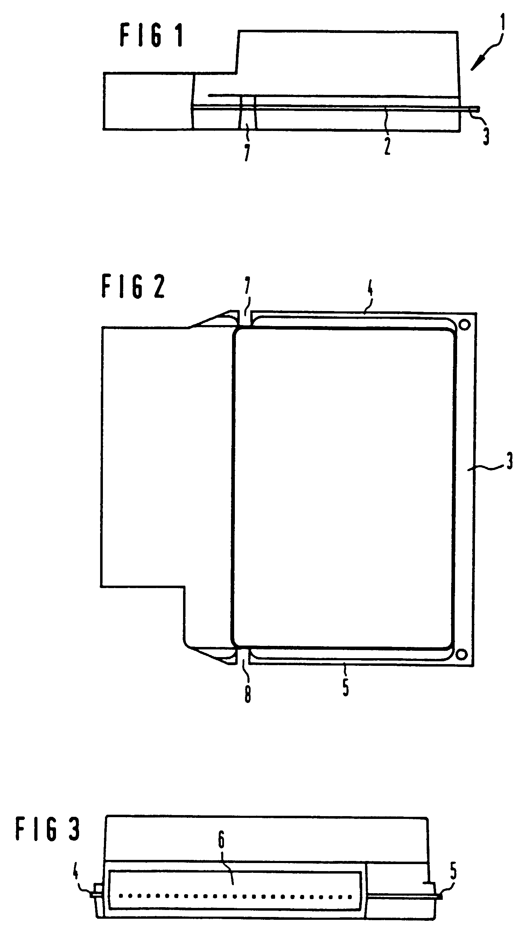

Figur 1 bis 3 zeigen den Einschubkörper 1, der ein Airbag-Steuergerät sein soll. Ein wesentliches Bauteil bildet der Träger 2 für nichtgezeigte elektrische Bauteile, der über den Einschubkörper 1 - hier an drei Seiten 3,4,5 - in seinem Randbereich hinausragt. Der Träger ist durch eine gestanzte Metallplatte gebildet, um die Herstellungskosten sowie die mechanische Steifigkeit des Trägers 2 zu erhöhen. Der Träger 2 ist durch einen aushärtbaren Schaum umschäumt, wodurch die gewünschte Form des Einschubkörpers 1 erreicht wird. In Figur 3 ist außerdem ein Steckerkörper 6 erkennbar, über den über einen Gegenstecker die elektrische Kontaktierung zu externen Einrichtungen herstellbar ist. Weiter ist in Figur 1 und 2 eine Ausnehmung 7,8 erkennbar, die im Träger 2 gebildet ist und die zur Verrastung des Einschubkörpers 1 dienen soll.

Figur 4 bis 6 zeigen das Steuergerät im zusammengebauten Zustand. Es ist ein Aufnahmekörper 9 vorgesehen, das auf einer Seite eine Öffnung 10 aufweist. An den Längsseiten 11,12 weist der Aufnahmekörper 9 nutenförmige Führungsaufnahmen 16,17 auf, in die die überstehenden Bereiche 4,5 (Figur 2) des Trägers 2 des Einschubkörpers 1 eingreifen. Zur Sicherung des Einschubkörpers 1 entgegen der Pfeilrichtung A im eingeschobenen Zustand weist der Aufnahmekörper 9 auf beiden Seiten als Rasthaken ausgebildete Federlappen 13,14 auf, die in diesem gezeigten Zustand in den entsprechenden Ausnehmungen 7,8 des Trägers 2 verrasten und diesen somit lagemäßig sichern. In Figur 4 ist mit Pos. 15 ein Gegenstecker bezeichnet, der den elektrischen Kontakt zum Stecker 6 herstellt. Erwähnenswert sind weiter die an den Seiten des Aufnahmekörpers 9 angeordneten Sicken, durch die die Steifigkeit des Aufnahmekörpers 9 zusätzlich verbessert wird.

## Patentansprüche

1. Steuergerät für ein Kraftfahrzeug, mit einer elektrischen Schaltung auf einem Träger (2), **dadurch gekennzeichnet,** daß Bauelemente der Schaltung von einem Einschubkörper (1) ummantelt sind, daß der Einschubkörper in einen Aufnahmekörper (9) eingeschoben ist, daß der Träger (2) über zumindest zwei Seitenflächen (3,4,5) des Einschubkörpers (1) hinausragt und in nutförmige Aufnahmen (16,17) des Aufnahmekörpers (9), welcher fest mit der Karosserie des Kraftfahrzeugs verbunden ist, eingreift.

2. Steuergerät nach Anspruch 1, dadurch gekennzeichnet, daß der Einschubkörper (1) aus ausgehärtetem Schaum besteht.

3. Steuergerät nach Anspruch 1, dadurch gekennzeichnet, daß der hinausragende Bereich des Trägers (2) Führungselemente für den Einschubkörper (1) bildet, die zumindest eine Aussparung (7,8) aufweisen, in die Federlappen (13,14) des Aufnahmekörpers (9) eingreifen, wenn der Einschubkörper (1) in einer Endstellung im Aufnahmekörper (9) angeordnet ist.

4. Steuergerät nach Anspruch 1, dadurch gekennzeichnet, daß im Bereich der Längsseiten des Aufnahmekörpers (9) Sicken angeordnet sind.

5. Steuergerät nach Anspruch 1, dadurch gekennzeichnet, daß der Träger (2) durch eine elektrische Leiterplatte gebildet ist.

6. Steuergerät nach Anspruch 1, dadurch gekennzeichnet, daß der Träger (2) durch eine zu Leiterbahnen gestanzte Metallplatte gebildet ist.

7. Steuergerät nach Anspruch 1, dadurch gekennzeichnet, daß der Aufnahmekörper (9) im Bereich einer Öffnung (10), die zur Aufnahme des Einschubkörpers (1) dient, gegenüber dem Einschubkörper (1) verlängert (B) ausgebildet ist.

8. Steuergerät nach Anspruch 1, dadurch gekennzeichnet, daß es ein Steuergerät für einen Airbag ist.

9. Steuergerät nach Anspruch 1, dadurch gekennzeichnet, daß der Einschubkörper (1) einen Stecker (6) zur Aufnahme eines Gegensteckers (15) enthält.

## Claims

1. Control unit for a motor vehicle with an electrical circuit on a carrier (2), **characterised in that** the components of the circuit are encased by a plug-in unit (1), that the plug-in unit is slid into a mounting (9), that the carrier (2) extends over at least two edges (3, 4, 5) of the plug-in unit (1) and engages in slots (16, 17) of the mounting (9) which is permanently secured to the body of the motor vehicle.

2. Control unit in accordance with claim 1, characterised in that the plug-in unit (1) consists of cured foam.

3. Control unit in accordance with claim 1, characterised in that the projecting area of the carrier (2) forms guides for the plug-in unit (1), which have at least one cutout (7, 8), into which the spring tabs (13, 14) of the mounting (9) engage when the plug-in unit (1) is in the fully plugged-in position in the mounting (9).

4. Control unit in accordance with claim 1, characterised in that reinforcing creases are arranged in the area of the long sides of the mounting (9).

5. Control unit in accordance with claim 1, characterised in that the carrier (2) is formed by an electrical circuit board.

6. Control unit in accordance with claim 1, characterised in that the carrier (2) is formed by a metal plate punched to form circuit tracks.

7. Control unit in accordance with claim 1, characterised in that the mounting (9) is extended (B) relative to the plug-in unit (1) in the area of an opening (10) which serves to take the plug-in unit (1).

8. Control unit in accordance with claim 1, characterised in that it is a control unit for an airbag.

9. Control unit in accordance with claim 1, characterised in that the plug-in unit (1) has a connector (6) to take a mating connector (15).

## Revendications

1. Appareil de commande pour véhicule automobile, avec un circuit électrique disposé sur un support (2), caractérisé en ce que les composants du circuit sont entourés d'un corps en forme de tiroir (1), en ce que le corps en forme de tiroir est glissé dans un corps de support (9), en ce que le support (2) dépasse du corps en forme de tiroir (1) par au moins deux faces latérales (3, 4, 5), et s'engage dans des logements en forme de rainure (16, 17) du corps de support (9), lequel est relié d'une façon fixe à la carrosserie du véhicule.

2. Appareil de commande suivant la revendication 1, caractérisé en ce que le corps en forme de tiroir (1) est constitué par une mousse thermodurcissable.

3. Appareil de commande suivant la revendication 1, caractérisé en ce que la zone débordante du support (2) forme des éléments de guidage pour le corps en forme de tiroir (1), lesquels présentent au moins un évidement (7, 8); dans lequel viennent s'encliqueter des lamelles à ressort (13,14) du corps de support (9), lorsque le corps en forme de tiroir (1) est placé dans une position finale dans le corps de support (9).

4. Appareil de commande suivant la revendication 1, caractérisé en ce que des moulures sont ménagées sur les côtés longitudinaux du corps de support (9).

5. Appareil de commande suivant la revendication 1, caractérisé en ce que le support (2) est constitué par une carte de circuit imprimé.

6. Appareil de commande suivant la revendication 1, caractérisé en ce que le support (2) est formé par une plaque métallique estampée pour former des pistes conductrices.

7. Appareil de commande suivant la revendication 1, caractérisé en ce que le corps de support (9) présente dans la zone d'une ouverture (10) destiné à recevoir le corps en forme de tiroir (1), est prolongé (B) au-delà du corps en forme de tiroir (1)

8. Appareil de commande suivant la revendication 1, caractérisé en ce que il constitue un appareil de commande pour un coussin gonflable.

9. Appareil de commande suivant la revendication 1, caractérisé en ce que le corps en forme de tiroir (1) comprend un connecteur mâle (6) destiné à recevoir un connecteur femelle (15).
